# EUROPEAN PATENT SPECIFICATION

(11) **EP 2 509 101 B1**
(45) Date of publication and mention of the grant of the patent: **09.09.2015**
(21) Application number: 10832874.1
(22) Date of filing: 30.11.2010
(51) Int. Cl.: H01L 21/02, B23K 20/00, B23K 20/14, B23K 20/24, B23K 101/40, H01L 21/18, H01L 21/67

(54) **BONDING METHOD, BONDING APPARATUS, AND BONDING SYSTEM**
BINDEVERFAHREN, BINDEVORRICHTUNG UND BINDESYSTEM
PROCÉDÉ DE COLLAGE, APPAREIL DE COLLAGE, ET SYSTÈME DE COLLAGE

(30) Priority: 30.11.2009 JP 2009271465
(43) Date of publication of application: 10.10.2012
(73) Proprietor: Mitsubishi Heavy Industries, Ltd., Tokyo 108-8215 (JP)
(72) Inventor: TSUTSUMI, Keiichiro, Tokyo 108-8215 (JP); TSUNO, Takeshi, Tokyo 108-8215 (JP); GOTO, Takayuki, Tokyo 108-8215 (JP); KINOUCHI, Masato, Tokyo 108-8215 (JP); SUZUKI, Takenori, Tokyo 108-8215 (JP); IDE, Kensuke, Tokyo 108-8215 (JP)
(74) Representative: Henkel, Breuer & Partner
(86) International application number: PCT/JP2010/006965
(87) International publication number: WO 2011/065025

(56) References cited:
- JP-A- 2007 201 196
- JP-A- 2007 201 196
- JP-A- 2009 200 075
- JP-A- 2009 200 075
- JP-A- 2009 260 007
- JP-A- 2009 260 007
- JP-A- 2009 534 842
- US-A1- 2007 246 450

## Description

### Technical Field

The present invention relates to a bonding method, and a boding system for bonding a plurality of substrates to form one substrate.

### Background Art

MEMS (Micro Electro Mechanical Systems) having microelectrical and micromechanical components integrated therein have been known. Examples of the MEMS include a micromachine, a pressure sensor, and an ultraminiature motor. These MEMS can be fabricated by bonding a plurality of wafers at room temperatures. A room temperature bonding apparatus for bonding two wafers at room temperatures has been known, and is disclosed in, for example, JP 3970304B (Patent Document 1). In the substrates obtained by bonding at room temperatures warpage may occur. Thus, it is desired to reduce warpage occurring in the substrates after bonding at room temperatures.

JP 2009-177034A (Patent Document 2) discloses a manufacturing method of a semiconductor wafer level package. The method described in Patent Document 2 is related to a manufacturing method of a semiconductor wafer level package in which a surface of a semiconductor wafer not bonded to a support substrate is processed, after bonding the semiconductor wafer to the support substrate, and characterized as follows: after the support substrate is bonded to the semiconductor wafer, a cutline with a certain depth from a surface of the support substrate or the semiconductor wafer is formed while the support substrate and the semiconductor wafer are in a bonded state, and then the surface of the semiconductor wafer not bonded to the support substrate is subjected to be processed.

JP 2008-300400A (Patent Document 3) discloses a manufacturing method of a semiconductor package substrate. The method described in Patent Document 3 is characterized by including the following steps: bonding a cap member to one surface of a semiconductor substrate including an electrode layer on the one surface via a resin layer or directly on the one surface to seal the electrode layer between the semiconductor substrate and the cap member; forming a through hole which penetrates through the semiconductor substrate from another surface of the semiconductor substrate to partially expose the electrode layer; forming a non-penetrating groove at a position corresponding to a dicing part of the semiconductor substrate from another surface of the semiconductor substrate, the non-penetrating groove not penetrating through the semiconductor substrate; and forming a penetrating wiring conducted to the electrode layer in the through hole in the semiconductor substrate having the through hole and the non-penetrating groove.

JP 2007-201196A discloses a wafer laminating device and method including an activation of the laminating surfaces of the wafers and a lamination of the wafers together at room temperatures. A bonding step is conducted just after the activating step.

### Summary of the Invention

### Technical Problems to be Solved by the Invention

The present invention aims to provide a bonding method and a bonding system for reducing warpage occurring in a bonded substrate with an approach different from conventional approaches.

The present invention also aims to provide a bonding method and a bonding system more reliably reducing warpage occurring in a bonded substrate.

### Solution to the Problems

The present invention provides a bonding system according to claim 1 and a bonding method according to claim 6. Means for solving the problems are described below by using reference characters with parentheses, the reference characters used in embodiments for carrying out the present invention and examples. These reference characters are added in order to clarify a correspondence between the description of the claims and the embodiments for carrying out the invention and the examples, and should not be used for interpretation of the technical scope of the invention described in the claims.

A bonding method according to the present invention includes an activating step (S2) of activating, by irradiating a first substrate surface of a first substrate and a second substrate surface of a second substrate with particles, the second substrate surface and the first substrate surface; and a bonding step (S4) of bonding the second substrate and the first substrate together by bringing the second substrate surface and the first substrate surface into contact with each other after a temperature difference between a temperature of the first substrate and a temperature of the second substrate becomes equal to or lower than a predetermined value. According to this bonding method, warpage occurring in a bonded substrate thus obtained can be further reduced compared with other conventional bonding methods of bonding both substrates before the temperature difference between the temperature of the first substrate and the temperature of the second substrate becomes equal to or lower than a predetermined value.

After the activating step (S2) and before the bonding step (S4), a temperature control step (S3) of heating or cooling the first substrate or the second substrate is provided. Thereby, the time until the temperature difference between the temperature of the first substrate and the temperature of the second substrate becomes equal to or lower than a predetermined value can be reduced, and enables the second substrate and the first substrate to be bonded together more quickly.

The bonding step (S4) is performed when the temperature of the first substrate or the temperature of the second substrate is included in a predetermined temperature range.

In the bonding method according to the present invention, the temperature difference between the temperature of the first substrate and the temperature of the second substrate is preferably measured by using a thermometer (18). Thus, the fact that the temperature difference becomes equal to or lower than the predetermined value can be more reliably detected.

A difference between a thermal conductivity of a first material (11, 8, 61) that is brought into contact with the first substrate when the first substrate surface is activated and a thermal conductivity of a second material (13, 51) that is brought into contact with the second substrate when the second substrate surface is activated is preferably in a predetermined range. Thus, the time until the temperature difference between the temperature of the first substrate and the temperature of the second substrate becomes equal to or lower than a predetermined value can be reduced.

The first material (11, 8, 61) is preferably a stainless steel, and the second material (13, 51) is preferably an alumina-based ceramic.

The bonding step (S4) may be performed after a lapse of five minutes or more from a time when the particle irradiation of the second substrate surface and the first substrate surface has been finished.

A bonding apparatus (1) of the bonding system according to the present invention includes: an activating apparatus (16) irradiating a first substrate surface of a first substrate and a second substrate surface of a second substrate with particles, and a pressure bonding mechanism (14) driving the second substrate and the first substrate so that the second substrate surface and the first substrate surface are in contact with each other after a temperature difference between a temperature of the first substrate and a temperature of the second substrate becomes equal to or lower than a predetermined value. According to the bonding apparatus (1), warpage occurring in a bonded substrate thus obtained can be further reduced compared with conventional bonding apparatuses for bonding the first substrate and the second substrate without considering the temperature difference between the temperature of the first substrate and the temperature of the second substrate.

The bonding apparatus (1) of the bonding system according to the present invention can further include a first holding mechanism (8, 9) for holding the first substrate when the first substrate surface is activated and a second holding mechanism (13) for holding the second substrate when the second substrate surface is activated. A difference between a thermal conductivity of a first material (11, 8, 61) that is brought into contact with the first substrate when the first substrate is held by the first holding mechanism (8, 9) and a thermal conductivity of a second material (13, 51) that is brought into contact with the second substrate when the second substrate is held by the second holding mechanism (13) is preferably in a predetermined range. According to this bonding apparatus (1), the time until the temperature difference between the temperature of the first substrate and the temperature of the second substrate becomes equal to or lower than a predetermined value can be reduced, and this allows the second substrate and the first substrate to be bonded together more quickly. As shown in an embodiment described further below, when the first material (11, 8, 61) is a stainless steel, and the second material (13, 51) is an alumina-based ceramic, even if the first substrate and the second substrate are bonded together immediately after the end of the activating process, the amount of warpage in the obtained bonded substrate can be reduced further than ever.

The bonding apparatus (1) of the bonding system according to the present invention can further include a heating device (61) for heating the first substrate. By heating the first substrate, this bonding apparatus (1) can reduce the time until the temperature difference between the temperature of the first substrate and the temperature of the second substrate becomes equal to or lower than a predetermined value.

The bonding apparatus (1) of the bonding system according to the present invention can further include a cooling device (62) for cooling the first substrate. By cooling the first substrate, this bonding apparatus (1) can reduce the time until the temperature difference becomes equal to or lower than the predetermined value.

The bonding apparatus (1) of the bonding system according to the present invention includes a temperature adjusting device (62) (64) for cooling or heating the second substrate. By cooling or heating the second substrate, this bonding apparatus (1) can reduce the time until the temperature difference between the temperature of the first substrate and the temperature of the second substrate becomes equal to or lower than a predetermined value.

The bonding apparatus (1) of the bonding system according to the present invention includes a thermometer (18) for measuring the temperature of the first substrate or/and the temperature of the second substrate. This bonding apparatus (1) can more reliably detect that the temperature difference between the temperature of the first substrate and the temperature of the second substrate becomes equal to or lower than a predetermined value.

### Advantageous Effects of Invention

In the bonding method and bonding system according to the present invention, after the temperature difference between the temperature of the first substrate and the temperature of the second substrate becomes equal to or lower than a predetermined value, that is, becomes a sufficiently small, the second substrate surface and the first substrate surface are bonded together. With this, warpage occurring in a bonded substrate with the second substrate and the first substrate bonded together can be reduced more than ever.

### Brief Description of Drawings

[FIG. 1] FIG. 1 is a sectional view showing a bonding apparatus of a bonding system according to the present invention.
[FIG. 2] FIG. 2 is a block diagram showing a boding-apparatus controller of a bonding system according to the present invention.
[FIG. 3] FIG. 3 is a flowchart showing a bonding method according to the present invention.
[FIG. 4] FIG. 4 is a sectional view schematically showing warpage occurring in a bonded substrate of a comparative example.
[FIG. 5] FIG. 5 is a sectional view schematically showing warpage occurring in a bonded substrate obtained by the bonding method according to the present invention.
[FIG. 6] FIG. 6 is a sectional view showing another electrostatic chuck including a cooling device.
[FIG. 7] FIG. 7 is a sectional view showing another electrostatic chuck including a heating device.
[FIG. 8] FIG. 8 is a sectional view showing another stage carriage including a cooling device.
[FIG. 9] FIG. 9 is a sectional view showing another stage carriage including a heating device.

### Description of Embodiments

With reference to the drawings, an embodiment of the bonding system according to the present invention is described.

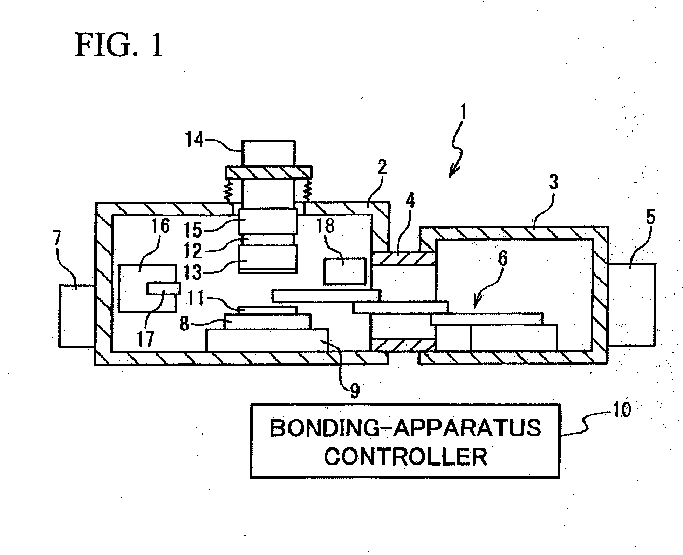

A bonding-apparatus controller 10 (hereinafter referred to as a "controller 10") is applied to a bonding system in the present embodiment, as shown in FIG. 1. That is, the bonding system includes the controller 10 and a bonding apparatus 1. The bonding apparatus 1 includes a bonding chamber 2 and a load lock chamber 3. The bonding chamber 2 and the load lock chamber 3 are configured so as to hermetically seal the inside of the chamber. The bonding apparatus 1 further includes a gate valve 4. The gate valve 4 is provided so as to be interposed between the bonding chamber 2 and the load lock chamber 3 to form a gate connecting the inside of the bonding chamber 2 and the inside of the load lock chamber 3. The gate valve 4 opens or closes its gate by being controlled by the controller 10. The load lock chamber 3 includes a lid not shown. This lid is opened and closed at the time of opening or closing a gate connecting the outside and inside of the load lock chamber 3 or taking out a bonded substrate.

The load lock chamber 3 includes a vacuum pump 5. Controlled by the controller 10, the vacuum pump 5 exhausts gas from the inside of the load lock chamber 3. Examples of the vacuum pump 5 include a turbo molecular pump, a cryopump, and an oil diffusion pump. The load lock chamber 3 further includes a substrate-transferring mechanism 6 inside. Controlled by the controller 10, the substrate-transferring mechanism 6 transfers a wafer placed inside the load lock chamber 3 via the gate valve 4 to the bonding chamber 2, or transfers the wafer placed in the bonding chamber 2 via the gate valve 4 to the inside of the load lock chamber 3.

The bonding chamber 2 includes a vacuum pump 7. Controlled by the controller 10, the vacuum pump 7 exhausts gas from the inside of the bonding chamber 2. Examples of the vacuum pump 7 include a turbo molecular pump, a cryopump, and an oil diffusion pump.

The bonding chamber 2 further includes a stage carriage 8 and a positioning mechanism 9. The stage carriage 8 is placed inside of the bonding chamber 2, and is supported so as to be movable in a translation manner in a horizontal direction and rotatably movable about a rotating axis parallel to a vertical direction. The stage carriage 8 is used to hold a cartridge 11. The cartridge 11 can be made of a stainless steel SUS 304, and is formed approximately in a disk shape. On the cartridge 11, a wafer is mounted. The cartridge 11 is provided so that the substrate-transferring mechanism 6 transfers the wafer without being in contact with the wafer. Controlled by the controller 10, the positioning mechanism 9 drives the stage carriage 8 so that the stage carriage 8 moves in the translation manner in the horizontal direction or rotatably moves as in the manner as described above.

The bonding chamber 2 further includes a pressure bonding shaft 12, an electrostatic chuck 13, a pressure bonding mechanism 14, and a load meter 15. The pressure bonding shaft 12 is supported so as to be movable in a translation manner in a vertical direction with respect to the bonding chamber 2. The electrostatic chuck 13 is placed at a lower end of the pressure bonding shaft 12. The electrostatic chuck 13 has an inner electrode placed inside a dielectric layer. The dielectric layer is made of an alumina-based ceramic, and has a flat surface formed thereon. The electrostatic chuck 13 is controlled by the controller 10, and a predetermined voltage is applied to the inner electrode thereof. With the predetermined voltage applied to the inner electrode of the electrostatic chuck 13, the electrostatic chuck 13 suctions the wafer placed near the flat surface of the dielectric layer by an electrostatic force. Controlled by the controller 10, the pressure bonding mechanism 14 causes the pressure bonding shaft 12 to move in a vertical direction with respect to the bonding chamber 2. The pressure bonding mechanism 14 further measures the position where the electrostatic chuck 13 is placed, and outputs the position to the controller 10. The load meter 15 measures a load applied onto the wafer held by the electrostatic chuck 13 by measuring the load applied onto the pressure bonding shaft 12, and outputs the load to the controller 10.

The positioning mechanism 9 further includes a plurality of alignment mechanisms not shown.

Controlled by the controller 10, each of the plurality of alignment mechanisms takes an image of the wafer held on the stage carriage 8, and takes an image of the wafer suctioned onto the electrostatic chuck 13.

The bonding chamber 2 further includes an ion gun 16 and an electron source 17. The ion gun 16 is placed so as to be oriented to a space between the positioning mechanism 9 and the electrostatic chuck 13 when the electrostatic chuck 13 is highly-placed. Controlled by the controller 10, the ion gun 16 discharges argon ions, the argon ions being accelerated to pass through the space between the positioning mechanism 9 and the electrostatic chuck 13 along an illumination axis crossing an inner surface of the bonding chamber 2. The electron source 17 is placed, like the ion gun 16, so as to be oriented to the space between the positioning mechanism 9 and the electrostatic chuck 13. Controlled by the controller 10, the electron source 17 discharges ions, the ions being accelerated to pass through the space between the positioning mechanism 9 and the electrostatic chuck 13 along another illumination axis crossing the inner surface of the bonding chamber 2.

The ion gun 16 further includes a metal target not shown. The metal target is made of a plurality of metals, and is placed at a position to be irradiated with argon ions. The metal target discharges particles of the plurality of metals to an atmosphere inside the bonding chamber 2 when irradiated with argon ions. The metal target can be replaced by a metal grid. The metal grid is a metal member with an opening, and is placed at an emission end of the ion gun 16. As with the metal target, when the metal grid is irradiated with argon ions, particles of the plurality of metals configuring the metal grid are discharged to the atmosphere inside the bonding chamber 2. Note that the metal target and the metal grid can be omitted when it is not required to attach metal on a bonding surface of the wafer.

The bonding chamber 2 further includes a thermometer 18. The thermometer 18 measures a temperature of the wafer mounted on the cartridge 11 held by the stage carriage 8. The thermometer 18 further measures a temperature of the wafer held by the electrostatic chuck 13.

The controller 10 is a computer, and includes a CPU, a storage device, a removable memory drive, an input device, and an interface that are not shown. The CPU executes a computer program installed on the controller 10 to control the storage device, the input device, and the interface. The storage device records the computer program, and temporarily records information generated by the CPU. The removable memory drive is used upon insertion of a recording medium to read data recorded on the recording medium. The removable memory drive is particularly used upon insertion of a recording medium having a computer program recorded thereon to install the computer program on the controller 10. The input device generates information by being operated by a user, and outputs the information to the CPU. An example of the input device is a keyboard. The interface outputs information generated by external devices connected to the controller 10 to the CPU, and outputs information generated by the CPU to the external devices. The external devices include the vacuum pump 5, the substrate-transferring mechanism 6, the vacuum pump 7, the positioning mechanism 9, the electrostatic chuck 13, the pressure bonding mechanism 14, the load meter 15, the ion gun 16, and the electron source 17.

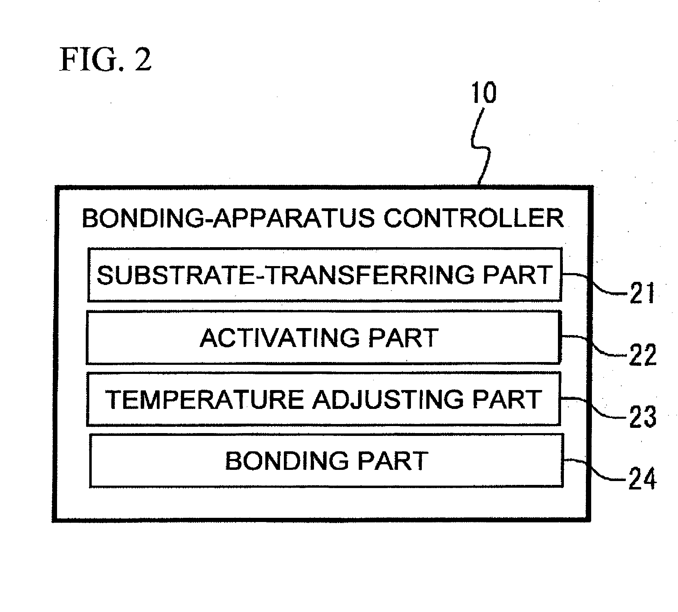

The computer program installed on the controller 10 may be made of a plurality of computer programs for achieving a plurality of functions by the controller 10. These plurality of functions include, as shown in FIG. 2, a substrate-transferring part 21, an activating part 22, a temperature adjusting part 23, and a bonding part 24.

The substrate-transferring part 21 controls the gate valve 4 so as to open and close the gate connecting the inside of the bonding chamber 2 and the inside of the load lock chamber 3. The substrate-transferring part 21 further controls the vacuum pump 5 so as to generate a preliminary atmosphere at a predetermined degree of vacuum inside the load lock chamber 3 or to generate an atmospheric-pressure atmosphere inside the load lock chamber 3, when the gate valve 4 is closed. When the gate valve 4 is opened, the substrate-transferring part 21 controls the substrate-transferring mechanism 6 so that the stage carriage 8 holds the cartridge 11 placed inside the load lock chamber 3 or to transfer the cartridge 11 held by the stage carriage 8 to the inside of the load lock chamber 3.

The substrate-transferring part 21 controls the alignment mechanisms of the positioning mechanism 9 so as to take an image of the wafer mounted on the cartridge 11 held by the stage carriage 8. The substrate-transferring part 21 controls the positioning mechanism 9 based on that image so that the wafer mounted on the cartridge 11 held by the stage carriage 8 is placed at a predetermined position. The substrate-transferring part 21 further controls the pressure bonding mechanism 14 so as to move the electrostatic chuck 13 in a translation manner. The substrate-transferring part 21 controls the electrostatic chuck 13 so that it holds the wafer or dechucks the wafer.

The activating part 22 controls the vacuum pump 7 so as to generate a bonding atmosphere at a predetermined degree of vacuum inside the bonding chamber 2, when the gate valve 4 is closed. Furthermore, when the bonding atmosphere is generated inside the bonding chamber 2, the activating part 22 controls the ion gun 16 so as to irradiate the wafer mounted on the cartridge 11 held by the stage carriage 8 with argon ions or to irradiate the wafer held by the electrostatic chuck 13 with argon ions. The activating part 22 further controls the electron source 17 so as to cause electrons to be discharged to a region to be irradiated with argon ions.

The temperature adjusting part 23 controls the thermometer 18 so as to measure a temperature of the wafer mounted on the cartridge 11 held by the stage carriage 8 or to measure a temperature of the wafer held by the electrostatic chuck 13. Based on the measured temperature, the temperature adjusting part 23 calculates timing when a temperature difference between the temperature of the wafer mounted on the cartridge 11 held by the stage carriage 8 and the temperature of the wafer held by the electrostatic chuck 13 becomes equal to or lower than a predetermined value.

When the electrostatic chuck 13 holds an upper wafer and a lower wafer is mounted on the cartridge 11 held by the stage carriage 8, the bonding part 24 controls the pressure bonding mechanism 14 so that the upper wafer and the lower wafer come close to each other with a predetermine distance. When the upper wafer and the lower wafer come close to each other with the predetermine distance, the bonding part 24 controls the alignment mechanisms of the positioning mechanism 9 so as to take an image of the upper wafer mounted on the cartridge 11 held by the stage carriage 8 and to take an image of the lower wafer held by the electrostatic chuck 13. When the upper wafer and the lower wafer are away from each other with the predetermine distance, the bonding part 24 further controls the positioning mechanism 9 so as to place the lower wafer at a predetermined position in a horizontal direction with respect to the upper wafer. The bonding part 24 further controls the pressure bonding mechanism 14 so that the upper wafer and the lower wafer are in contact with each other at the timing calculated by the temperature adjusting part 23. Based on the load measured by the load meter 15, the bonding part 24 calculates timing when the measured load reaches a predetermined load, and controls the pressure bonding mechanism 14 so as to stop the electrostatic chuck 13 at that timing.

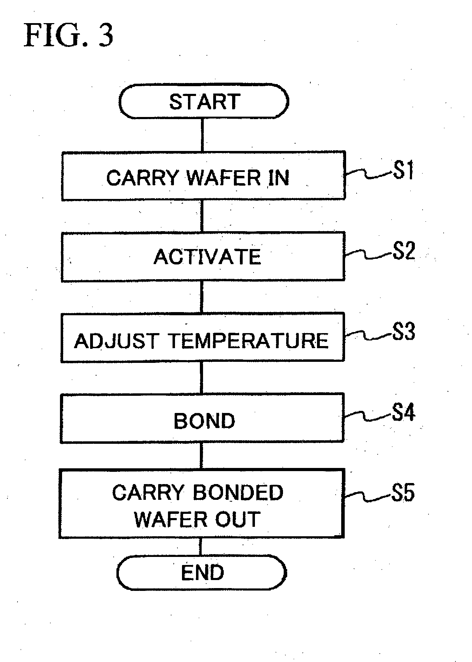

FIG. 3 is a flowchart showing a bonding method according to the present invention. The operator first controls the gate valve 4 so as to close the gate connecting the bonding chamber 2 and the load lock chamber 3, controls the vacuum pump 7 so as to generate a vacuum atmosphere inside the bonding chamber 2, and controls the vacuum pump 5 so as to generate an atmospheric-pressure atmosphere inside the load lock chamber 3. The operator mounts an upper wafer on the cartridge 11 and a lower wafer on another cartridge 11. After the atmospheric-pressure atmosphere is generated inside the load lock chamber 3, the operator opens the lid of the load lock chamber 3, and carries the upper wafer together with the cartridge 11 and carries the lower wafer together with the cartridge 11 into the inside of the load lock chamber 3. The operator then closes the lid of the load lock chamber 3 to generate a vacuum atmosphere inside the load lock chamber 3.

After the vacuum atmosphere is generated inside the load lock chamber 3, the controller 10 opens the gate valve 4. The controller 10 first controls the substrate-transferring mechanism 6 so that the stage carriage 8 holds the cartridge 11 having the upper wafer mounted thereon. The controller 10 controls the substrate-transferring mechanism 6 so that it moves to the inside of the load lock chamber 3. The controller 10 then controls the alignment mechanisms of the positioning mechanism 9 so as to take images of an alignment marks formed on the upper wafer. Based on that image, the controller 10 controls the positioning mechanism 9 so as to place the upper wafer at a predetermined position in a horizontal direction. The controller 10 controls the pressure bonding mechanism 14 so that the dielectric layer of the electrostatic chuck 13 is in contact with the upper wafer, and controls the electrostatic chuck 13 so that it sucks the upper wafer. The controller 10 controls the pressure bonding mechanism 14 to cause the upper wafer to be away from the cartridge 11. After the upper wafer goes away from the cartridge 11, the controller 10 controls the substrate-transferring mechanism 6 so as to transfer the cartridge 11 where the upper wafer is not mounted from the stage carriage 8 to the inside of the load lock chamber 3.

After the upper wafer is held by the electrostatic chuck 13, the controller 10 controls the substrate-transferring mechanism 6 so that the stage carriage 8 holds the cartridge 11 having a lower wafer mounted thereon. The controller 10 then controls the alignment mechanisms of the positioning mechanism 9 so as to take images of alignment marks formed on the lower wafer. The controller 10 controls the positioning mechanism 9 so as to place the lower wafer at a predetermined position in a horizontal direction based on the images (step S1).

The controller 10 then closes the gate valve 4, and controls the vacuum pump 7 so as to generate a bonding atmosphere at a predetermined degree of vacuum inside the bonding chamber 2. When the inside of the bonding chamber 2 is under the bonding atmosphere generated, the controller 10 controls the ion gun 16 so as to discharge particles toward a space between the upper wafer and the lower wafer, while the upper wafer held by the electrostatic chuck 13 and the lower wafer held by the stage carriage 8 are away from each other. Irradiation with these particles is performed on a front side surface of the upper wafer and a front side surface of the lower wafer, oxides and others formed on these surfaces are removed, and impurities attached on these surfaces are removed. Irradiation of these particles is also performed on the metal target provided on the ion gun 16. Then, the metal particles configuring the metal target are discharged to the atmosphere inside the bonding chamber 2. The metal target may be made of a plurality of metals. The discharged metal particles are deposited on the front side surface of the upper wafer and the front side surface of the lower wafer (step S2).

The controller 10 then controls the thermometer 18 so as to measure the temperature of the wafer mounted on the cartridge 11 held by the stage carriage 8 or to measure the temperature of the wafer held by the electrostatic chuck 13. Based on the measured temperature, the controller 10 calculates timing when a temperature difference between the temperature of the wafer mounted on the cartridge 11 held by the stage carriage 8 and the temperature of the wafer held by the electrostatic chuck 13 becomes equal to or lower than a predetermined value (step S3).

The controller 10 controls the pressure bonding mechanism 14 so that the upper wafer and the lower wafer move away from each other with a predetermined distance. The controller 10 then controls the alignment mechanisms of the positioning mechanism 9 so as to take images of alignment marks formed on the upper wafer and images of alignment marks formed on the lower wafer. Based on the taken images, the controller 10 controls the positioning mechanism 9 so as to bond the upper wafer and the lower wafer as designed. Note that such highly-accurate positioning may be omitted if not required. An example of the case where highly-accurate positioning is not required is such that no structure is formed on the upper wafer or the lower wafer.

The controller 10 controls the pressure bonding mechanism 14 so that the upper wafer is in contact with the lower wafer at the timing calculated in step S3. The upper wafer and the lower wafer are bonded by the contact to form one bonded substrate (step S4).

The controller 10 controls the electrostatic chuck 13 so as to dechuck a bonded substrate 41, and controls the pressure bonding mechanism 14 so that the electrostatic chuck 13 rises in a upper vertical direction. The controller 10 then opens the gate valve 4, and controls the substrate-transferring mechanism 6 so as to transfer the cartridge 11 where the bonded substrate 31 is mounted from the stage carriage 8 to the load lock chamber 3. The controller 10 closes the gate valve 4, and controls the vacuum pump 5 so as to generate an atmospheric-pressure atmosphere inside the load lock chamber 3. After the atmospheric-pressure atmosphere is generated inside the load lock chamber 3, the operator opens the lid of the load lock chamber 3 to take out the bonded substrate 31 (step S5).

The upper wafer and the lower wafer have their temperatures rise by irradiation with argon beams. Since the thermal conductivity of a material in contact with the upper wafer and the thermal conductivity of a material in contact with the lower wafer are different from each other, the temperature of the upper wafer and the temperature of the lower wafer are different from each other immediately after irradiation of argon beams.

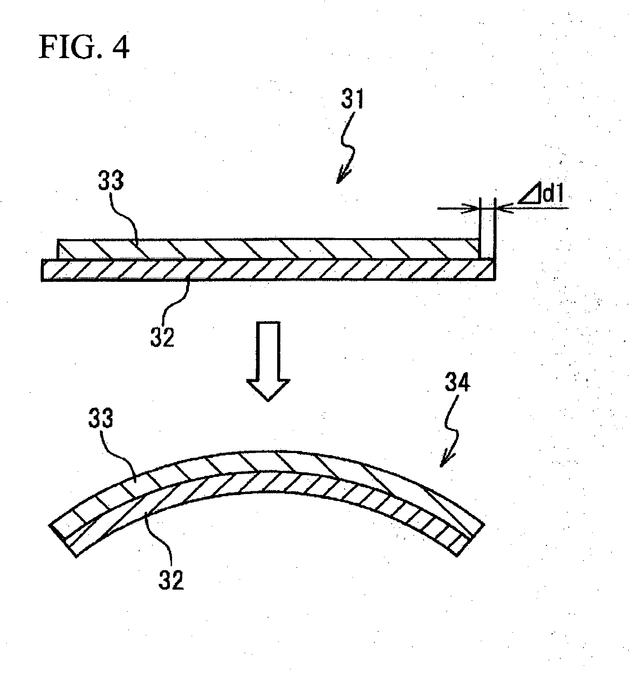

In room-temperature bonding, generally, in order to increase bonding strength, the time from the time when the upper wafer and the lower wafer are irradiated with argon beams to the time when the upper wafer and the lower wafer are bonded together is shortened. FIG. 4 schematically shows a section of a bonded substrate with a relatively short period of time from activation to bonding. The bonded substrate 31 is fabricated by bonding a lower wafer 32 and an upper wafer 33 together. A temperature difference between the temperature of the lower wafer 32 and the temperature of the upper wafer 33 is relatively large because the thermal conductivity of the material in contact with the lower wafer 32 and the thermal conductivity of the material in contact with the upper wafer 33 are different from each other. Here, a difference Δd1 between the amount of extension of the lower wafer 32 and the amount of extension of the upper wafer 33 is relatively large. Thus, relatively large warpage occurs in a bonded substrate 34 after the bonded substrate 31 is cooled.

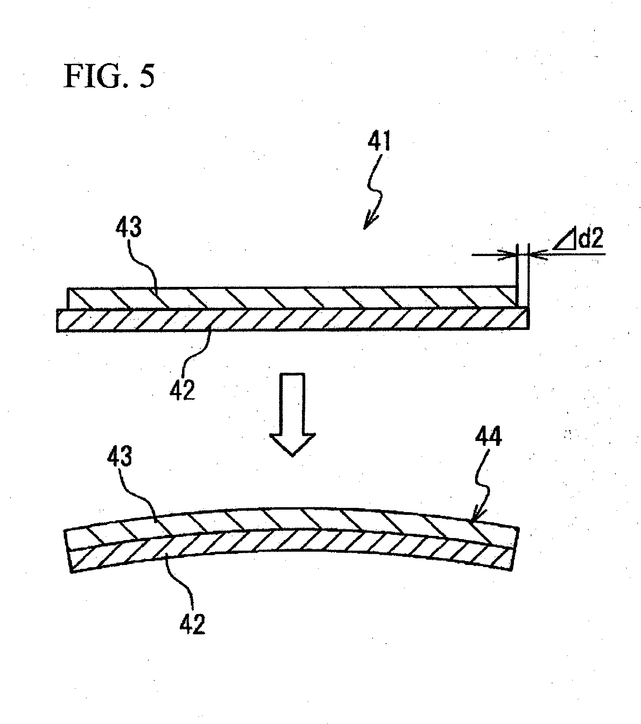

FIG. 5 schematically shows a section of the bonded substrate obtained by the bonding method according to the present invention. A bonded substrate 41 is fabricated by bonding a lower wafer 42 and an upper wafer 43 together. A difference Δd2 between the amount of extension of the lower wafer 42 and the amount of extension of the upper wafer 43 is relatively small compared with the difference Δd1 because a temperature difference between the temperature of the lower wafer 42 and the temperature of the upper wafer 43 is relatively small. Thus, warpage is more reduced in a bonded substrate 44 after the bonded substrate 41 is cooled, compared with the bonded substrate 34.

That is, the bonding method according to the present invention can more reduce warpage of the bonded wafer (bonded substrate). As a result, according to the bonding method in accordance with the present invention, equipment in subsequent processes for processing the bonded wafer can handle the bonded wafer more easily. Examples of the subsequent processes include a process of further bonding the bonded wafer to another wafer, a process of bonding a wiring tube of the bonded wafer, an inspecting process, and a dicing process.

The lower wafer 42 is in contact with the cartridge 11 during a period from the time when the lower wafer 42 is activated to the time when it is bonded. The stainless steel SUS 304 forming the cartridge 11 has a thermal conductivity of approximately 16.3 W/m.K. The upper wafer 43 is in contact with the dielectric layer of the electrostatic chuck 13 during a period from the time when the upper wafer 43 is activated to the time when it is bonded. The alumina-based ceramic forming the dielectric layer has a thermal conductivity of approximately 32 W/m·K. Here, the aluminum-nitride-based ceramic has a thermal conductivity of approximately 150 W/m·K. That is, the alumina-based ceramic has a thermal conductivity close to the thermal conductivity of the stainless steel SUS 304, compared with the thermal conductivity of the aluminum-nitride-based ceramic. Thus, in the bonding apparatus 1 according to the present invention, compared with another bonding apparatus in which the dielectric layer of the electrostatic chuck 13 is made of an aluminum-nitride-based ceramic, the temperature difference between the temperature of the lower wafer 42 and the temperature of the upper wafer 43 is reduced, and the period when the temperature difference between the temperature of the lower wafer 42 and the temperature of the upper wafer 43 becomes equal to or lower than a predetermined temperature difference (for example, five degrees), furthermore, equal to or lower than three degrees, can be shortened, thereby allowing the lower wafer 42 and the upper wafer 43 to be bonded more quickly. When the cartridge 11 and the stage carriage 8 are made of the stainless steel SUS 304 and the dielectric layer of the electrostatic chuck 13 is made of an alumina-based ceramic, even if the lower wafer 42 and the upper wafer 43 are bonded together immediately after the activating process ends, the amount of warpage in a bonded substrate thus obtained can be reduced more than ever. Therefore, in this case, the temperature control step (S3) may be omitted.

Note that the cartridge 11 may be made of a material different from the stainless steel SUS 304. The material preferably has a thermal conductivity that is close to the thermal conductivity of the material configuring the dielectric layer of the electrostatic chuck 13 and is in a predetermined range. An example of the predetermined range is larger than 1/2 of the thermal conductivity of the dielectric layer of the electrostatic chuck 13 and smaller than twice the thermal conductivity of the dielectric layer of the electrostatic chuck 13. Another example of the predetermined range is such that a difference from the thermal conductivity of the dielectric layer of the electrostatic chuck 13 is within 20 W/m.K. Specifically, an example of combination is such that the dielectric layer of the electrostatic chuck 13 is made of an alumina-based ceramic and the cartridge 11 is made of the stainless steel SUS 430.

Note that the stage carriage 8 may be replaced by another stage carriage holding a wafer so as to be in direct contact with the wafer without the cartridge 11. In this case, the stage carriage is made of the same material as that configuring the cartridge 11. Even in a bonding apparatus including this stage carriage, as with the bonding apparatus 1 in the embodiment described above, the period until the time when the temperature difference between the temperature of the lower wafer and the temperature of the upper wafer becomes equal to or lower than a predetermined value after the activating step can be shortened.

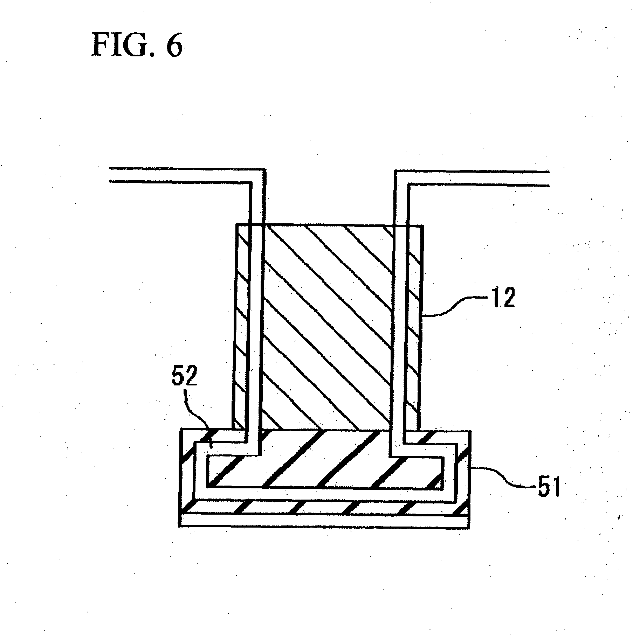

An example in which the electrostatic chuck 13 and the stage carriage 8 are replaced by another electrostatic chuck and another stage carriage is shown in FIG. 6 to FIG. 9.

As shown in FIG. 6, an electrostatic chuck 51 includes a cooling device. The cooling device includes a coolant channel 52 and a cooling device body not shown. The coolant channel 52 has one part placed inside the electrostatic chuck 51 and the other part placed outside the bonding apparatus 1. The cooling device body is placed outside the bonding apparatus 1. A coolant at a predetermined temperature flows through the coolant channel 52, and thereby the wafer held by the electrostatic chuck 51 is cooled.

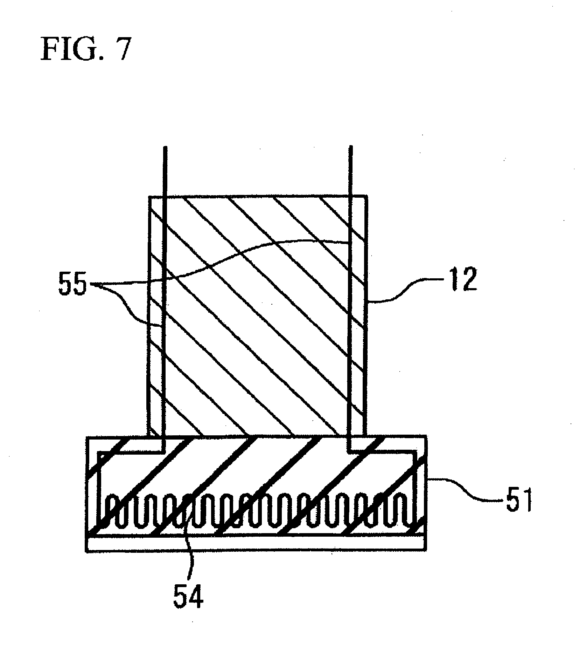

Also, as shown in FIG. 7, the electrostatic chuck 51 includes a heating device. The heating device includes a heater 54 and an electric wire 55, and includes a heating device body not shown. The heater 54 produces heat by being applied with a voltage. The electric wire 55 is electrically connected to the heater 54. The heating device body heats the wafer held by the electrostatic chuck 51 by applying a voltage to the heater 54 via the electric wire 55.

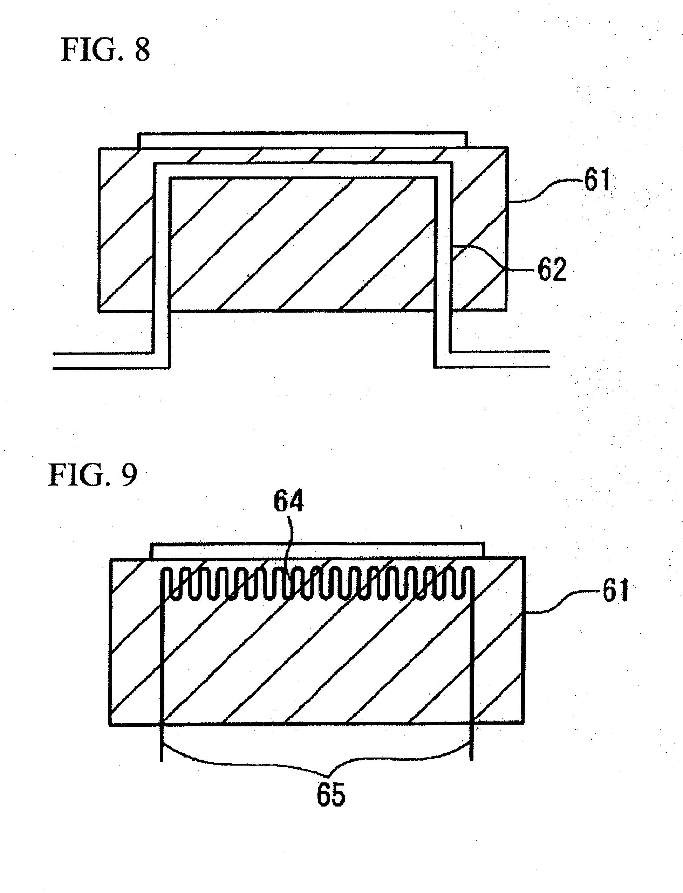

As shown in FIG. 8, the stage carriage 61 includes a cooling device. The cooling device includes a coolant channel 62 and a cooling device body not shown. The coolant channel 62 has one part placed inside the stage carriage 61 and the other part placed outside the bonding apparatus 1. The cooling device body is placed outside the bonding apparatus 1. A coolant at a predetermined temperature flows through the coolant channel 62, and thereby the wafer held by the stage carriage 61 is cooled.

Also, as shown in FIG. 9, the stage carriage 61 includes a heating device. The heating device includes a heater 64 and an electric wire 65, and includes a heating device body not shown. The heater 64 produces heat by being applied with a voltage. The electric wire 65 is electrically connected to the heater 64. The heating device body heats the wafer held by stage carriage 61 by applying a voltage to the heater 64 via the electric wire 65.

The temperature adjusting part 23 of the controller 10 controls the thermometer 18 so as to measure the temperature of the wafer held by the electrostatic chuck 51. Based on the measured temperature, the temperature adjusting part 23 controls the cooling device or the heating device of the electrostatic chuck 51 so that the temperature of the wafer held by the electrostatic chuck 51 is in a predetermined temperature range. The temperature adjusting part 23 further controls the thermometer 18 so as to measure the temperature of the wafer held immediately in contact with the stage carriage 61. Based on the measured temperature, the temperature adjusting part 23 controls the cooling device or the heating device of the stage carriage 61 so that the temperature of the wafer held by the stage carriage 61 is in a predetermined temperature range. The temperature adjusting part 23 further calculates timing when the temperature of the wafer held by the electrostatic chuck 51 is included in the predetermined temperature range and the temperature of the wafer held by the stage carriage 61 is included in the predetermined temperature range. An example of the predetermined temperature range is a range of temperatures of an atmosphere in which the bonded wafer obtained by bonding is handled in a subsequent process, and another example is a range of temperatures of an atmosphere in which a MEMS fabricated from the bonded wafer is used.

As with the bonding apparatus 1 shown in FIG. 1, the above-described bonding apparatus can further reduce warpage occurring in the bonded wafer in the predetermined temperature range. Even if the temperature of the atmosphere in a subsequent process is different from room temperatures, the above-described bonding apparatus can reduce warpage of the bonded wafer in the subsequent process, and can make the bonded wafer more easy to handle in the subsequent process. Furthermore, the above-described bonding apparatus can change the temperature of the wafer held by the electrostatic chuck 51 or the stage carriage 61 to a predetermined temperature more quickly, can shorten the period from activation until the temperature difference between the temperature of the lower wafer and the temperature of the upper wafer becomes equal to or lower than a predetermined value, and can bond the lower wafer and the upper wafer more quickly. Still further, even if the lower wafer and the upper wafer are made of materials with different thermal conductivities, the above-described bonding apparatus can shorten the period until the temperature difference becomes equal to or lower than a predetermined value, and can bond the lower wafer and the upper wafer more quickly.

Note that when the lower wafer and the upper wafer are not required to be temperature-controlled at a temperature lower than wafer ordinary temperatures, the cooling device can be omitted from the electrostatic chuck 51 and the stage carriage 61. Similarly, when the lower wafer and the upper wafer are not required to be temperature-controlled at a temperature sufficiently higher than the wafer ordinary temperatures, the heating device can be omitted from the electrostatic chuck 51 and the stage carriage 61.

Note that in the bonding apparatus 1 shown in FIG. 1, only the electrostatic chuck 13 may be replaced by the electrostatic chuck 51. Here, the temperature adjusting part 23 of the controller 10 controls the thermometer 18 so as to measure the temperature of the wafer held in direct contact with the stage carriage 8. Based on the measured temperature, the temperature adjusting part 23 controls the cooling device or the heating device of the electrostatic chuck 51 so that a temperature difference between the temperature of the wafer held by the electrostatic chuck 51 and the temperature of the wafer held by the stage carriage 8 becomes equal to or lower than a predetermined value. As with the bonding apparatus 1 using the electrostatic chuck 13, the bonding apparatus using the electrostatic chuck 51 including the cooling device or the heating device can reduce warpage and, compared with the bonding apparatus 1, can shorten the time required in the temperature control step (S3), and therefore can bond more quickly.

Note that in the bonding apparatus 1 shown in FIG. 1, only the stage carriage 8 may be replaced by the stage carriage 61. Here, the temperature adjusting part 23 of the controller 10 controls the thermometer 18 so as to measure the temperature of the wafer held by the electrostatic chuck 13. Based on the measured temperature, the temperature adjusting part 23 controls the cooling device or the heating device of the stage carriage 61 so that a temperature difference between the temperature of the wafer held by the stage carriage 61 and the temperature of the wafer held by the electrostatic chuck 13 becomes equal to or lower than a predetermined value. As with the bonding apparatus 1 using the stage carriage 8, the bonding apparatus using the stage carriage 61 including the cooling device or the heating device can reduce warpage and, compared with the bonding apparatus 1, can shorten the time required in the temperature control step (S3), and therefore can bond more quickly.

Furthermore, as another example, not related to the present invention, the thermometer 18 may be omitted from the bonding apparatus 1 shown in FIG. 1. Here, a user calculates a period from activation until a temperature difference between the temperature of the lower wafer and the temperature of the upper wafer becomes equal to or lower than a predetermined value based on a previous experiment. The period is shorter than a period from activation until the effect of activation of the lower wafer and the upper wafer is erased (for example, ten minutes). The period is approximately constant irrespectively of the attributes of the wafer, the electrostatic chuck, and the stage carriage and, for example, equal to or longer than five minutes. The temperature adjusting part 23 of the controller 10 calculates timing after a lapse of that period from the time when the wafer activating step ends. As with the bonding apparatus 1 including the thermometer 18, even this bonding apparatus can reduce warpage.

### Examples

By using the bonding system shown in FIG. 1, a bonded substrate was fabricated with the following conditions.

### <First Condition (Example)>

The electrostatic chuck 13 was made of an alumina-based ceramics, and the stage carriage 8 was made of the stainless steel SUS 304. The used alumina-based ceramic has a thermal conductivity of 32 W/m.K, and the stainless steel SUS 304 has a thermal conductivity of 16.3 W/m.K.

The activation time in the activating step S2 was set at five minutes. After the activating step S2, the second substrate surface and the first substrate surface were brought into contact with each other, thereby bonded both substrates. Note that disk-shaped wafers (with a diameter of 4 inches) made of silicon (SiO₂ each with an oxide film were used as the first substrate and the second substrate. Also, in the first condition, a process of heating or cooling the first substrate and the second substrate was not performed, and a wait time was not provided between the activating step S2 and the bonding step S4.

### <Second Condition (Comparative Example)>

As with the first condition, the stage carriage 8 was made of the stainless steel SUS 304, but the electrostatic chuck 13 was made of an aluminum-nitride-based ceramic. The aluminum-nitride-based ceramic used has a thermal conductivity of 150 W/m.K.

As with the first condition, the activation time in the activating step S2 was set at five minutes. After the activating step S2, the second substrate surface and the first substrate surface were brought into contact with each other, thereby bonded both substrates. Note that, also in the second condition, disk-shaped wafers (with a diameter of 4 inches) made of silicon (SiO₂) each with an oxide film were used as the first substrate and the second substrate. Also in the second condition, a process of heating or cooling the first substrate and the second substrate was not performed, and a wait time was not provided between the activating step S2 and the bonding step S4.

In a bonded substrate obtained in the second condition, as depicted in FIG. 4, significant warpage was confirmed. A specific amount of warpage, Δd1, was approximately 100 µm to 150 µm.

By contrast, in a bonded substrate obtained in the first condition, as depicted in FIG. 5, warpage was reduced. A specific amount of warpage, Δd2, was approximately 30 µm.

Note that the amounts of warpage, Δd1 and Δd2, were obtained by measuring the wafer surface shape with a step meter.

In the first condition, a difference in thermal conductivity between the electrostatic chuck 13 (alumina-based ceramics) and the stage carriage 8 (stainless steel SUS 304) is 15.7 W/m.K. On the other hand, in the second condition, a difference in thermal conductivity between the electrostatic chuck 13 (aluminum-nitride-based ceramic) and the stage carriage 8 (stainless steel SUS 304) is 133.7 W/m.K. It has been confirmed that, by making the difference in thermal conductivity between the electrostatic chuck 13 and the stage carriage 8 small as in the first condition, the amount of warpage in the bonded substrate thus obtained can be significantly reduced even if a process of heating or cooling the first substrate and the second substrate is not performed and no wait time is provided between the activating step S2 and the bonding step S4.

### <Third Condition (Example)>

As with the second condition, the stage carriage 8 was made of the stainless steel SUS 304, and the electrostatic chuck 13 was made of an aluminum-nitride-based ceramic. The aluminum-nitride-based ceramic used has a thermal conductivity of 150 W/m.K.

The activation time in the activating step S2 was set at five minutes, and a wait time until a temperature difference between the temperature of the first substrate and the temperature of the second substrate becomes equal to or lower than a predetermined value (=5°C) was set. After a lapse of the wait time, the second substrate surface and the first substrate surface were brought into contact with each other, thereby bonded both substrates. Note that disk-shaped wafers (with a diameter of 4 inches) made of silicon (SiO₂) each with an oxide film were used as the first substrate and the second substrate.

Even in a bonded substrate obtained in the third condition, warpage was reduced as shown in FIG. 5. A specific amount of warpage, Δd2, was approximately 30 µm.

It has been confirmed that, after the temperature difference between the temperature of the first substrate and the temperature of the second substrate becomes equal to or lower than the predetermined value, the second substrate surface and the first substrate surface are brought into contact with each other, thereby allowing a significant reduction in the amount of warpage in the bonded substrate thus obtained.

### Reference Signs List

- 1:: bonding apparatus
- 2:: bonding chamber
- 3:: load lock chamber
- 4:: gate valve
- 5:: vacuum pump
- 6:: substrate-transferring mechanism
- 7:: vacuum pump
- 8:: stage carriage
- 9:: positioning mechanism
- 10:: bonding-apparatus controller (controller)
- 11:: cartridge
- 12:: pressure bonding shaft
- 13:: electrostatic chuck
- 14:: pressure bonding mechanism
- 15:: load meter
- 16:: ion gun
- 17:: electron source
- 18:: thermometer
- 21:: substrate-transferring part
- 22:: activating part
- 23:: temperature adjusting part
- 24:: bonding part
- 31:: bonded substrate
- 32:: lower wafer
- 33:: upper wafer
- 34:: bonded substrate
- 41:: bonded substrate
- 42:: lower wafer
- 43:: upper wafer
- 44:: bonded substrate
- 51:: electrostatic chuck
- 52:: coolant channel
- 54:: heater
- 55:: electric wire
- 61:: stage carriage
- 62:: coolant channel
- 64:: heater
- 65:: electric wire

## Claims

1. A bonding system comprising:
a bonding apparatus (1) including
an activating apparatus (16,17) for irradiating a first substrate surface of a first substrate and a second substrate surface of a second substrate with particles,
a thermometer (18) for measuring the temperature of the first substrate or/and the temperature of the second substrate,
a temperature adjusting device (52,54, 62, 64) for cooling or heating the first and/or the second substrate, and
a pressure bonding mechanism (14) for driving the second substrate and the first substrate so that the second substrate surface and the first substrate surface are in contact with each other; and
a controller (10) for controlling the bonding apparatus (1), wherein the controller (10) includes
an activating part (22) arranged to control the activating apparatus (16,17) to irradiate the first substrate surface of a first substrate and the second substrate surface of a second substrate with particles to activate the substrate surfaces,
a bonding part (24) arranged to control the pressure bonding mechanism (14) so that it drives the second substrate and the first substrate to bond the second substrate and the first substrate together after a temperature difference between the temperature of the first substrate and the temperature of the second substrate becomes equal to or lower than a predetermined value, **characterised in that** the bonding system further comprises
a temperature adjusting part (23) arranged to control the temperature adjusting device (52,54,62,64) to heat and/or cool the first substrate and/or the second substrate after an activating step (S2) and before bonding step (S4) based on the temperature measured by the thermometer (18) so that the temperature of the first substrate surface and of the second substrate surface are in a predetermined range.

2. The bonding system according to claim 1, wherein the bonding apparatus further comprises:
a first holding mechanism for holding the first substrate when the first substrate surface is activated; and
a second holding mechanism for holding the second substrate when the second substrate surface is activated, wherein
a difference between a thermal conductivity of a first material that is brought into contact with the first substrate when the first substrate is held by the first holding mechanism and a thermal conductivity of a second material that is brought into contact with the second substrate when the second substrate is held by the second holding mechanism is in a predetermined temperature range.

3. The bonding system according to claim 2, wherein
the first material is a stainless steel, and
the second material is an alumina-based ceramic.

4. The bonding system according to claim 1, 2 or 3, wherein the predetermined range of the temperature of the first substrate surface and the temperature of the second substrate surface is a range of temperatures of an atmosphere in which the bonded substrates are handled in a subsequent process.

5. The bonding system according to claim 1, 2, 3 or 4, wherein the predetermined value of the temperature difference between the temperature of the first substrate and the temperature of the second substrate is five degrees or lower.

6. A bonding method comprising:
an activating step (S2) of activating, by irradiating a first substrate surface of a first substrate and a second substrate surface of a second substrate with particles, the second substrate surface and the first substrate surface;
a bonding step (S4) of bonding the second substrate and the first substrate together by bringing the second substrate surface and the first substrate surface into contact with each other after the difference between the temperature of the first substrate and the temperature of the second substrate becomes equal to or lower than a predetermined value, **characterised in that** the bonding method further comprises
a temperature control step (S3) of controlling the temperature of the first and/or second substrate after the activating step (S2) and before the bonding step (S4), by heating and/or cooling the first substrate and/or the second substrate so that the temperature of the first substrate surface and of the second substrate surface are in a predetermined range.

7. The bonding method according to claim 6, wherein the temperature difference is measured by using a thermometer (18).

8. The bonding method according to claim 6, wherein the bonding step (S4) is performed after a lapse of five minutes or more from a time when the particle irradiation of the second substrate surface and the first substrate surface has been finished.

9. The bonding method according to claim 6, 7 or 8, wherein the predetermined range of the temperature of the first substrate surface and the temperature of the second substrate surface is a range of temperatures of an atmosphere in which the bonded substrates are handled in a subsequent process.

10. The bonding method according to claim 6, 7, 8 or 9, wherein the predetermined value of the temperature difference between the temperature of the first substrate and the temperature of the second substrate is five degrees or lower.

## Patentansprüche

1. Ein Bondingsystem mit:
einer Bondingvorrichtung (1) mit
einer Aktivierungsvorrichtung (16, 17) zum Bestrahlen einer ersten Substratoberfläche eines ersten Substrats und einer zweiten Substratoberfläche eines zweiten Substrats mit Teilchen,
einem Thermometer (18) zum Messer der Temperatur des ersten Substrats oder/und der Temperatur des zweiten Substrats,
einer Temperatur-Einstellvorrichtung (52,54,62,64) zum Kühlen oder Erwärmen des ersten und/oder des zweiten Substrats, und
einem Druck-Bondingmechanismus (14) zum Antreiben des zweiten Substrats und des ersten Substrats so, dass die zweite Substratoberfläche und die erste Substratoberfläche in Kontakt miteinander sind, und
einem Kontroller (10) zum Steuern der Bondingvorrichtung (1), wobei der Kontroller (10) aufweist
ein Aktivierungsteil (22), das angeordnet ist, um die Aktivierungsvorrichtung (16,17) anzusteuern, dass sie die erste Substratoberfläche eines ersten Substrats und die zweite Substratoberfläche eines zweiten Substrats mit Teilchen bestrahlt, um die Substratoberflächen zu aktivieren,
ein Bondingteil (24), das angeordnet ist, um den Druck-Bondingmechanismus (14) so zu steuern, dass er das zweite Substrat und das erste Substrat antreibt, um das zweite Substrat und das erste Substrat miteinander zu bonden, nachdem eine Temperaturdifferenz zwischen der Temperatur des ersten Substrats und der Temperatur des zweiten Substrats gleich oder kleiner wird als ein vorbestimmter Wert,
**dadurch gekennzeichnet, dass** das Bondingsystem ferner aufweist
ein Temperatur-Einstellteil (23), das angeordnet ist, um die Temperatur-Einstellvorrichtung (52,54,62,64) anzusteuern, damit diese das erste Substrat und/oder das zweite Substrat erwärmt und/oder kühlt, nach einem Aktivierungsschritt (S2) und vor einem Bondingschritt (S4), basierend auf der durch das Thermometer (18) gemessenen Temperatur, sodass die Temperatur der ersten Substratoberfläche und der zweiten Substratoberfläche in einem vorbestimmten Bereich sind.

2. Das Bondingsystem gemäß Anspruch 1, wobei die Bondingvorrichtung ferner aufweist:
einen ersten Haltemechanismus zum Halten des ersten Substrats, wenn die erste Substratoberfläche aktiviert wird, und
einen zweiten Haltemechanismus zum Halten des zweiten Substrats, wenn die zweite Substratoberfläche aktiviert wird, wobei
eine Differenz zwischen einer thermischen Leitfähigkeit eines ersten Materials, das in Kontakt mit dem ersten Substrat gebracht wird, wenn das erste Substrat durch den ersten Haltemechanismus gehalten ist, und einer thermischen Leitfähigkeit eines zweiten Materials, das in Kontakt mit dem zweiten Substrat gebracht wird, wenn das zweite Substrat durch den zweiten Haltemechanismus gehalten ist, in einem vorbestimmten Temperaturbereich ist.

3. Das Bondingsystem gemäß Anspruch 2, wobei
das erste Material Edelstahl ist, und
das zweite Material eine Aluminiumoxid-basierte Keramik ist.

4. Das Bondingsystem gemäß Anspruch 1, 2 oder 3, wobei der vorbestimmte Bereich der Temperatur der ersten Substratoberfläche und der Temperatur der zweiten Substratoberfläche in einem Bereich von Temperaturen in einer Atmosphäre ist, in der die gebondeten Substrate einem nachfolgenden Prozess gehandhabt werden.

5. Das Bondingsystem gemäß Anspruch 1, 2, 3 oder 4, wobei der vorbestimmte Wert der Temperaturdifferenz zwischen der Temperatur des ersten Substrat und der Temperatur des zweiten Substrats fünf Grad oder weniger beträgt.

6. Ein Bondingverfahren mit:
einem Aktivierungsschritt (S2) des Aktivierens, durch Bestrahlen einer ersten Substratoberfläche eines ersten Substrats und einer zweiten Substratoberfläche eines zweiten Substrats mit Teilchen, der zweiten Substratoberfläche und der ersten Substratoberfläche,
einem Bondingschritt (S4) des Bondens des zweiten Substrats und des ersten Substrats miteinander, indem die zweite Substratoberfläche und die erste Substratoberfläche in Kontakt miteinander gebracht werden, nachdem die Differenz zwischen der Temperatur des ersten Substrats und der Temperatur des zweiten Substrats gleich oder kleiner wird als ein vorbestimmter Wert,
**dadurch gekennzeichnet, dass** das Bondingverfahren ferner aufweist
einen Temperatur-Steuerschritt (S3) des Steuerns der Temperatur des ersten und/oder des zweiten Substrats, nach dem Aktivierungsschritt (S2) und vor dem Bondingschritt (S4), durch Erwärmen und/oder Kühlen des ersten Substrats und/oder des zweiten Substrats, sodass die Temperatur der ersten Substratoberfläche und der zweiten Substratoberfläche in einem vorbestimmten Bereich sind.

7. Das Bondingverfahren gemäß Anspruch 6, wobei die Temperaturdifferenz durch Anwenden eines Thermometers (18) gemessen wird.

8. Das Bondingverfahren gemäß Anspruch 6, wobei der Bondingschritt (S4) nach einem Ablauf von fünf Minuten oder mehr von einem Zeitpunkt, wenn die Teilchenbestrahlung der zweiten Substratoberfläche und der ersten Substratoberfläche beendet worden ist, ausgeführt wird.

9. Das Bondingverfahren gemäß Anspruch 6, 7 oder 8, wobei der vorbestimmte Bereich der Temperatur der ersten Substratoberfläche und der Temperatur der zweiten Substratoberfläche ein Bereich von Temperaturen einer Atmosphäre ist, in welcher die gebondeten Substrate in einem nachfolgenden Prozess gehandhabt werden.

10. Das Bondingverfahren gemäß Anspruch 6, 7, 8 oder 9, wobei der vorbestimmte Wert der Temperaturdifferenz zwischen der Temperatur des ersten Substrats und der Temperatur des zweiten Substrats fünf Grad oder weniger beträgt.

## Revendications

1. Système de liaison, comprenant :
un dispositif (1) de liaison, comprenant :
un dispositif (16, 17) d'activation pour exposer une surface d'un premier substrat et une surface d'un deuxième substrat à des particules,
un thermomètre (18) de repérage de la température du premier substrat et/ou de la température du deuxième substrat,
un dispositif (52, 54, 62, 64) de réglage de la température pour refroidir ou chauffer le premier et/ou le deuxième substrat et
un mécanisme (14) de liaison par la pression pour entraîner le deuxième substrat et le premier substrat de manière à ce que la surface du deuxième substrat et que la surface du premier substrat soient en contact l'une avec l'autre et
une unité (10) de commande du dispositif (1) de liaison, l'unité (10) de commande comprenant
une partie (22) d'activation, agencée pour commander le dispositif (16, 17) d'activation pour exposer la surface d'un premier substrat et la surface d'un deuxième substrat à des particules afin d'activer les surfaces des substrats,
une partie (24) de liaison, agencée pour commander le mécanisme (24) de liaison par la pression, de manière à ce qu'il entraîne le deuxième substrat et le premier substrat pour lier le deuxième substrat et le premier substrat ensemble après qu'une différence de température entre la température du premier substrat et la température du deuxième substrat devient inférieure ou égale à une valeur déterminée à l'avance, **caractérisé en ce que** le système de liaison comprend, en outre,
une partie (23) de réglage de la température agencée pour commander le dispositif (52, 54, 62, 64) de réglage de la température afin de chauffer et/ou de refroidir le premier substrat et/ou le deuxième substrat après un stade (S2) d'activation et avant un stade (S4) de liaison reposant sur la température repérée par le thermomètre (18), de manière à ce que la température de la surface du premier substrat et de la surface du deuxième substrat soient dans une plage déterminée à l'avance.

2. Système de liaison suivant la revendication 1, dans lequel le dispositif de liaison comprend, en outre :
un premier mécanisme de maintien pour maintenir le premier substrat lorsque la surface du premier substrat est activée et
un deuxième mécanisme de maintien pour maintenir le deuxième substrat lorsque la surface du deuxième substrat est activée, dans lequel
une différence entre une conductibilité thermique d'un premier matériau, qui est mis en contact avec le premier substrat quand le premier substrat est maintenu par le premier mécanisme de substrat, et une conductibilité thermique d'un deuxième matériau, qui est mis en contact avec le deuxième substrat lorsque le deuxième substrat est maintenu par le deuxième mécanisme de maintien, est dans une plage de température déterminée à l'avance.

3. Système de liaison suivant la revendication 2, dans lequel le premier matériau est un acier inoxydable et le deuxième matériau est une céramique à base d'alumine.

4. Système de liaison suivant la revendication 1, 2 ou 3, dans lequel la plage déterminée à l'avance de la température de la surface du premier substrat et de la température de la surface du deuxième substrat est une plage de température d'une atmosphère dans laquelle les substrats liés sont manipulés dans une opération venant ensuite.

5. Système de liaison suivant la revendication 1, 2, 3 ou 4, dans lequel la valeur déterminée à l'avance de la différence de température entre la température du premier substrat et la température du deuxième substrat est inférieure ou égale à cinq degrés.

6. Procédé de liaison, comprenant :
un stade (S2) d'activation, dans lequel on active, en exposant une surface d'un premier substrat et une surface d'un deuxième substrat à des particules, la surface du deuxième substrat et la surface du premier substrat,
un stade (S4) de liaison du deuxième substrat et du premier substrat ensemble en mettant la surface du deuxième substrat et la surface du premier substrat en contact l'une avec l'autre après que la différence entre la température du premier substrat et la température du deuxième substrat devient inférieure ou égale à une valeur déterminée à l'avance, **caractérisé en ce que** le procédé de liaison comprend, en outre
un stade (S3) de réglage de la température du premier et/ou du deuxième substrat après le stade (S2) d'activation et avant le stade (S4) de liaison en chauffant et/ou en refroidissant le premier substrat et/ou le deuxième substrat, de manière à ce que la température de la surface du premier substrat et de la surface du deuxième substrat soient dans une plage déterminée à l'avance.

7. Procédé de liaison suivant la revendication 6, dans lequel on mesure la différence de température en utilisant un thermomètre (18).

8. Procédé de liaison suivant la revendication 6, dans lequel on effectue le stade (S4) de liaison après un laps de temps de cinq minutes ou plus à partir d'un instant où l'exposition aux particules de la surface du deuxième substrat et de la surface du premier substrat est finie.

9. Procédé de liaison suivant la revendication 6, 7 ou 8, dans lequel la plage déterminée à l'avance de la température de la surface du premier substrat et de la température de la surface du deuxième substrat est une plage de température d'une atmosphère dans laquelle les substrats liés sont manipulés dans une opération venant ensuite.

10. Procédé de liaison suivant la revendication 6, 7, 8 ou 9, dans lequel la valeur déterminée à l'avance de la différence de température de la température du premier substrat et de la température du deuxième substrat est inférieure ou égale à cinq degrés.
